Europäisches Patentamt

European Patent Office

Office européen des brevets

(19)

(11) Veröffentlichungsnummer : **0 191 332**
**B1**

(12) **EUROPÄISCHE PATENTSCHRIFT**

(45) Veröffentlichungstag der Patentschrift :
23.11.89

(21) Anmeldenummer : 86100884.5

(22) Anmeldetag : 23.01.86

(51) Int. Cl.⁴ : **H 04 N   3/185**, H 03 K   4/62

(54) Fernsehempfänger mit einem Schaltnetzteil und einer Horizontalablenkschaltung.

(30) Priorität : 09.02.85 DE 3504485

(43) Veröffentlichungstag der Anmeldung :
20.08.86 Patentblatt 86/34

(45) Bekanntmachung des Hinweises auf die Patenterteilung : 23.11.89 Patentblatt 89/47

(84) Benannte Vertragsstaaten :
AT BE CH DE FR GB IT LI LU NL SE

(56) Entgegenhaltungen :
GB-A- 2 133 186
ELECTRONIQUE ET MICROELECTRONIQUE INDUS-
TRIELLES, Nr. 220, Mai 1976, Seiten 28-31, Paris, FR;
J.C. PERRIN: "Ticlops: un circuit d'alimentation à
découpage et de déflexion horizontale à un seul
transistor"

(73) Patentinhaber : Deutsche Thomson-Brandt GmbH
Hermann-Schwer-Strasse 3 Postfach 1307
D-7730 Villingen-Schwenningen (DE)

(72) Erfinder : Hartmann, Uwe
Tallardstrasse 15
D-7730 Villingen-Schwenningen (DE)
Erfinder : Mai, Udo
Mühleschweg 2
D-7730 VS-Villingen 23 (DE)

EP 0 191 332 B1

**Beschreibung**

Die Erfindung geht aus von einem Fernsehempfänger mit einem Schaltnetzteil und einer Horizontalablenkschaltung wie er im Oberbegriff des Patentanspruchs definiert ist.

Eine solche Schaltung ist z. B. in der DE-C-21 30 902 beschrieben. Hierbei wird der Schalttransistor sowohl für die Netzteilfunktion zur Erzeugung mehrerer stabiler Betriebsspannungen als auch für die Horizontalablenkung ausgenützt. Durch mehr oder weniger langes Durchschalten des Schalters können Last- und Netzspannungsschwankungen ausgeregelt werden, so daß sekundärseitig stabile Betriebsspannungen entnehmbar sind. Je kleiner die Netzspannung ist, desto länger muß der Schalter geschlossen werden. Der Schalter muß bei Abweichungen zu höheren Netzspannungen länger geöffnet bleiben. Die Schaltung hat den Nachteil, daß der Regelbereich nach oben, d. h. nach höheren Netzspannungen begrenzt ist, weil der Schalter zur Aufrechterhaltung des Zeilenablenkstromes während der zweiten Ablenkhälfte immer geschlossen bleiben muß, dadurch ist der Regelbereich auf 1 : 2 begrenzt. Daraus ergibt sich, daß der elektronische Schalter für eine kürzere Zeitspanne pro Ablenkzyklus geöffnet sein könnte, wenn er nicht für die Ablenkung zur Verfügung stehen müßte. Abhilfe wäre, einen gesonderten Schalter für die Ablenkung vorzusehen. Dieses Konzept verteuert jedoch unnötig die Schaltung.

Der Erfindung liegt die Aufgabe zugrunde, unter Beibehaltung der Doppelausnützung des elektronischen Schalters, den Regelbereich der Netzteilfunktion nach oben zu erweitern. Diese Aufgabe wird durch das Merkmal des Patentanspruchs gelöst mit dem Vorteil eines geringen Schaltungsaufwandes unter Umgehung eines teueren zusätzlichen Leistungsschalters.

Nachstehend wird die Erfindung an einem Ausführungsbeispiel beschrieben.

Figur 1 zeigt die wesentlichen Teile der Schaltung ;

Figur 2 zeigt Diagramme zur Erläuterung der Schaltung nach Figur 1.

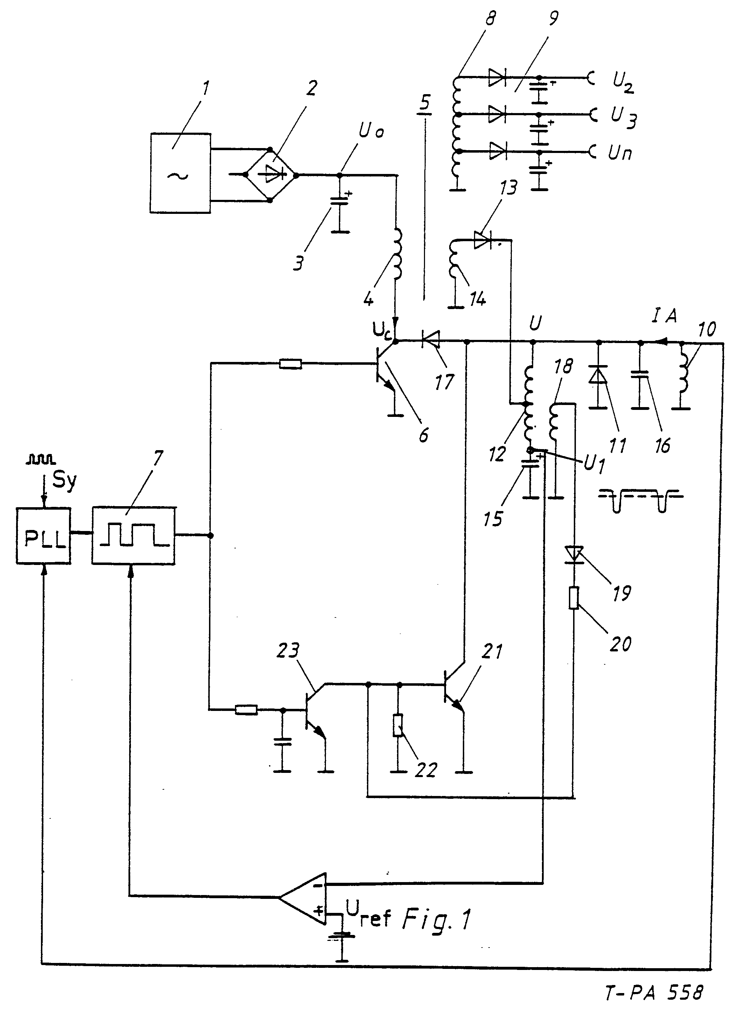

In Figur 1 ist die bekannte Netzteil-Horizontalablenkkombination im wesentlichen dargestellt. Hierzu ist über eine Wechselspannungsquelle 1 eine Gleichrichterschaltung 2 an einen Ladekondensator 3 angeschlossen. An dem Ladekondensator 3 bildet sich die noch ungeregelte gleichgerichtete Betriebsspannung UO aus. Diese ist an die Primärwicklung 4 eines Transformators 5 geschaltet, dessen anderes Ende über einen elektronischen Schalter 6 auf Massepotential schaltbar ist. Dies geschieht je nach Belastung des Transformators 5 über eine Steuerschaltung 7, welche in Abhängigkeit von der Belastung impulsbreiten-modulierte Impulse abgibt. Wenn der elektronische Schalter 6 geschlossen wird, fließt Strom durch die Primärwicklung 4 des Transformators 5. Nach einem Impuls aus der Steuerschaltung 7 wird der elektronische Schalter geöffnet und die in der Primärwicklung 4 gespeicherte magnetische Energie wird auf die Sekundärseite 8 + 14 übertragen, an welcher über verschiedene Anzapfungen und Gleichrichterkreise 9 die unterschiedlichen Betriebsspannungen + U1 bis Un entstehen. Sinkt infolge höherer Belastung des Netzteils die Spannung ab, wird der elektronische Schalter 6 früher eingeschaltet, so daß mehr Energie übertragen werden kann.

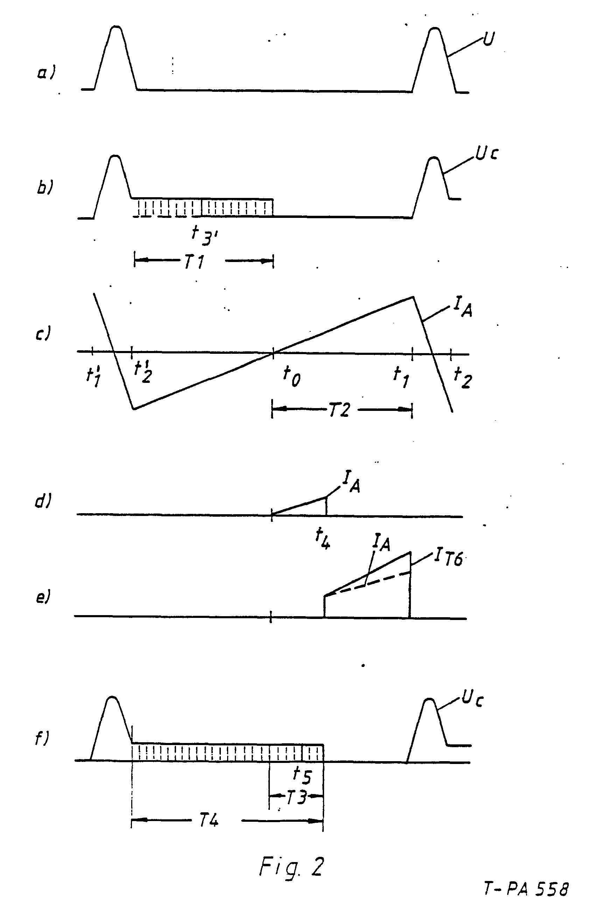

Bei dem bekannten Schaltungskonzept dient der elektronische Schalter 6 auch noch als Schalter für die Horizontalablenkung Dieser muß während der zweiten Zeilenhinlaufhälfte immer geschlossen sein, damit der durch die Ablenkwicklung 10 fließende positive Ablenkstrom über diesen nach Masse fließen kann. Der negativ gerichtete Ablenkstrom wird von der Diode 11 übernommen. Die Ablenkwicklung 10 ist an die Primärwicklung 12 eines Zeilentransformators angeschaltet, der eine Anzapfung besitzt, die über eine Diode 13 mit einer Sekundärwicklung 14 des Schaltnetzteiltransformators 5 verbunden ist. Das andere Ende der Zeilentransformatorwicklung 12 ist über einen Kondensator 15 mit Masse verbunden. Parallel zur Ablenkwicklung 10 ist ein Kondensator 16 in bekannter Weise geschaltet. Eine Diode 17 dient zur Entkopplung während der gesperrten Phase des elektronischen Schalters 6. Die bis hierhin beschriebene Schaltung arbeitet als Netzteil und zur Zeilenablenkung in bekannter Weise. An der Zeilentransformatorwicklung 12 steht die Spannung U nach Figur 2a. Am Kollektor des elektronischen Schalters 6 bildet sich eine Spannung Uc aus nach Figur 2b mit einer hohen Rücklaufspannung. Während des Zeilenhinlaufs liegt am Kollektor des elektronischen Schalters 6 entweder die gleichgerichtete Spannung UO oder die Spannung UCE des durchgeschalteten Schalters 6. Der Schalter 6 ist während der zweiten Hinlaufhälfte ab Zeitpunkt to geschlossen (Figur 2c) und übernimmt den Ablenkstrom aus der Ablenkwicklung 10 bis zum Zeitpunkt t1. Es folgt der Zeilenrücklauf bis zum Zeitpunkt t2, t2' von dem ab der Ablenkstrom durch die Diode 11 fließt bis zum Zeitpunkt to. Die Regelung für das Netzteil kann durch entsprechendes zeitliches Zuschalten des Schalters 6 zu Zeitpunkten t3' während des Zeitraums T1 erfolgen, wie in Figur 2b angedeutet ist. Da der elektronische Schalter 6 während des Zeitraumes T2 immer geschlossen ist, steht er während dieser Zeit für die Regelung nicht mehr zur Verfügung.

Um diesen Mangel zu beseitigen, wird zusätzlich zur bisher beschriebenen Schaltung über eine Sekundärwicklung 18 des Zeilentransformators die Hinlaufspannung der Zeilenablenkung über eine Diode 19 und einen Widerstand 20 an die Basis eines zusätzlichen Transistors 21 geschaltet, der mit seiner Kollektor-Emitterstrecke parallel zur Ablenkwicklung 10 liegt. Durch die gleichgerichtete Hinlaufspannung am Widerstand 22 zwischen Basis und Emitter des Transistors 21 wird dieser durchgeschaltet. Dies geschieht während einer Zeitspanne T4, bis er durch die Steuerschaltung 7 zum Zeitpunkt t4 gesperrt wird. (Figur 2d) Während der zeitpanne T3 übernimmt der Transistor 21 den anfänglichen Ablenkstrom. Sobald die Steuerschaltung 7 den elektronischen Schalter 6 einschaltet, wird über den Transistor 23 der Transistor 21 abgeschaltet. Von diesem Zeitpunkt ab fließt der gesamte Ablenkstrom durch den elektronischen Schalter 6 (Figur 2e). Dieser Strom setzt sich zusammen aus dem Ablenkstrom und dem Strom aus der Wicklung 4 des Transformators 5. Wie aus Figur 2f hervorgeht, steht nun der elektronische Schalter 6 während des Zeitraums T3 zusätzlich zur Regelung zur Verfügung und kann zu beliebigen Zeitpunkten t5 durchgeschaltet werden. Hierdurch wird erreicht, daß bei erhöhter Netzspannung weniger Energie aus dem Transformator entnehmbar ist und dadurch der Regelbereich erweitert ist. Für den Transistor 21 kann im Gegensatz zum Transistor des Schalters 6 ein kleiner Transistor verwendet werden, da er nur den anfänglichen , geringen Ablenkstrom übernimmt. Auch an die Schaltgeschwindigkeit und die Verlustleistung werden keine großen Anforderungen gestellt, da der Transistor mit Nullspannung ein- und ausgeschaltet wird. Lediglich die Sperrspannung muß der Rücklaufspannung entsprechend angepaßt sein.

**Patentansprüche**

1. Fernsehempfänger mit einem Schaltnetzteil und einer Horizontalablenkschaltung, wobei die Betriebsspannungen für den Fernsehempfänger durch periodisches Schließen und öffnen eines in Serie zu der Primärwicklung (4) eines Transformators (5) liegenden elektronischen Schalters (6) gewonnen werden, indem die während der durchgeschalteten Phase des elektronischen Schalters (6) in der Primärwicklung (4) gespeicherte magnetische Energie auf die Sekundärseite des Transformators übertragen wird, woraus durch Gleichrichtung verschieden hohe Betriebsspannungen erzeugt werden und parallel zum elektronischen Schalter die Primärwicklung (12) des Zeilentransformators des Fernsehempfägners geschaltet ist, an welche die Horizontalablenkwicklung (10) angeschlossen ist, wobei der durch die Ablenkwicklung (10) fließende positive Ablenkstrom durch den elektronischen Schalter (6) fließt und der negative Ablenkstrom durch eine parallel zur Ablenkwicklung geschaltete Diode (11) fließt und die erzeugten Betriebsspannungen bei Netzspannungsschwankungen innerhalb eines vorgegebenen Regelbereichs dadurch stabilisiert sind, daß der elektronische Schalter (6) während der leitenden Phase der Diode (11) durch impulsbreitenmodulierte Impulse mehr oder weniger lang leitend gesteuert wird, dadurch gekennzeichnet, daß zur Erweiterung des Regelbereichs parallel zum elektronischen Schalter (6) ein Hilfsstromkreis (18-23) geschaltet wird, der während des Anfangs der zweiten Zeilenhinlaufhälfte den Ablenkstrom (IA) übernimmt.

2. Fernsehempfänger nach Anspruch 1, dadurch gekennzeichnet, daß der Hilfsstromkreis (18-23) während eines Teils des zeilenhinlaufs eingeschaltet ist.

3. Fernsehempfänger nach Anspruch 1, dadurch gekennzeichnet, daß der Hilfsstromkreis (18-23) bei Einschalten des durch die impulsbreiten-modulierte Steuerspannung gesteuerten elektronischen Schalters (6) unterbrochen wird.

**Claims**

1. A television receiver with a switching network part and a horizontal sweep circuit, in which the operating voltages for the television receiver are obtained by periodically closing and opening an electronic switch (6) which is in series with the primary winding (4) of a transformer (5), the magnetic energy stored in the primary winding (4) during the through connected phase of the electronic switch (6) being transferred to the secondary side of the transformer, from which, by rectification, operating voltages of different magnitudes are produced and the primary winding (12) of the line transformer of the television receiver is connected parallel to the electronic switch, to which the horizontal sweep winding (10) is connected, wherein the positive sweep current flowing through the sweep winding (10) flows through the electronic switch (6) and the negative sweep current flows through a diode (11) connected parallel to the sweep winding, and the operating voltages produced when there are mains voltage swings are stabilised within a predetermined control range by the fact that the electronic switch (6) is controlled to be conductive for differing lengths of time during the conductive phase of the diode (11) by means of pulse width modulated pulses, characterised in that in order to broaden the control range an auxiliary circuit (18-23), which takes over the sweep current (IA) during the beginning of the second outgoing line propagation time, is connected in parallel with the electronic switch (6).

2. A television receiver according to claim 1, characterised in that the auxiliary current circuit (18-23) is switched on during a part of the outgoing line propagation time.

3. A television receiver according to claim 1, characterised in that the auxiliary current circuit (18-23) is broken when switching on the electronic switch (6) controlled by the pulse width modulated control voltage.

**Revendications**

1. Récepteur de télévision comportant un bloc d'alimentation secteur et un circuit de balayage horizontal, et dans lequel les tensions de service pour le récepteur de télévision sont obtenues par ouverture et fermeture périodique d'un interrupteur électronique (6) branché en série avec l'enroulement primaire (4) d'un transformateur (5), par le fait que l'énergie magnétique, stockée dans l'enroulement primaire (4) pendant la phase de conduction de l'interrupteur électronique (6), est transmise au côté secondaire du transformateur, qu'à partir de là des tensions de service possédant des amplitudes différentes sont produites par redressement et qu'en parallèle avec l'interrupteur électronique se trouve branché l'enroulement primaire (12) du transformateur de lignes du récepteur de télévision, auquel est raccordé l'enroulement de déviation horizontale (10), et dans lequel le courant positif de déviation, qui circule dans l'enroulement de déviation (10), traverse l'interrupteur électronique (6) et le courant négatif de balayage traverse une diode (11) branchée en parallèle avec l'enroulement de déviation, et les tensions de service produites sont stabilisées à l'intérieur d'une plage prédéterminée de régulation, dans le cas de variations de la tension du secteur, grâce au fait que, pendant la phase de conduction de la diode (11), l'interrupteur électronique (6) est commandé par des impulsions, modulées en durée, de manière à être conducteur plus ou moins longtemps, caractérisé en ce que, pour accroître la plage de régulation, en parallèle avec l'interrupteur électronique (6) se trouve branché un circuit auxiliaire (18-23) qui prend en charge le courant de balayage (IA), au début de la seconde moitié du balayage aller d'une ligne.

2. Récepteur de télévision selon la revendication 1, caractérisé en ce que le circuit auxiliaire (18-23) est branché pendant une partie du balayage aller d'une ligne.

3. Récepteur de télévision selon la revendication 1, caractérisé en ce que le circuit auxiliaire (18-23) est interrompu lors du passage à l'état conducteur de l'interrupteur électronique (6) commandé par la tension de commande modulée selon une modulation d'impulsions en durée.

Fig. 1

T-PA 558

Fig. 2

T-PA 558